# EUROPÄISCHE PATENTANMELDUNG

(11) **EP 4 312 010 A1**
(43) Veröffentlichungstag der Anmeldung: **31.01.2024**
(21) Anmeldenummer: 22187364.9
(22) Anmeldetag: 28.07.2022
(51) Int. Cl.: G01K 7/18, H01C 17/24, H01C 17/28, H05K 1/18, H01C 1/144

(54) **HERSTELLUNG VON SENSORMODULEN MIT EINEM UNDERFILL-PROZESS**

(71) Anmelder: Yageo Nexensos GmbH, 63801 Kleinostheim (DE)
(72) Erfinder: Girschikofsky, Maiko, 63801 Kleinostheim (DE); Schwappach, Bastian, 63801 Kleinostheim (DE); Nick, Christoph, 63801 Kleinostheim (DE); Asmus, Tim, 63801 Kleinostheim (DE)
(74) Vertreter: Kilchert, Jochen

(57) **Zusammenfassung**

Die Erfindung betrifft ein Sensormodul aufweisend ein Sensorelement, umfassend einen elektrisch isolierenden Träger aufweisend eine erste Seite und eine der ersten Seite gegenüberliegende zweite Seite, wobei eine Widerstandsstruktur auf der ersten Seite des isolierenden Trägers angeordnet ist und wobei die Widerstandsstruktur mindestens eine Sensorstruktur, mindestens eine Trimmstruktur und mindestens zwei Kontaktpads enthält und ein Substrat aufweisend eine erste Oberfläche mit mindestens zwei darauf angeordneten Leiterstrukturen, wobei das Sensorelement mit der ersten Seite des isolierenden Trägers hin zur ersten Oberfläche des Substrats angeordnet ist, dadurch gekennzeichnet, dass zwischen mindestens einem Kontaktpad des Sensorelements und mindestens einer Leiterstruktur des Substrats eine Lotverbindung ausgebildet ist und dass zwischen dem Sensorelement und dem Substrat zumindest ein polymeres Isolationsmaterial vorliegt und bevorzugt mindestens die Trimmstruktur bedeckt. Weiterhin betriff die Erfindung ein Verfahren zur Herstellung des Sensormoduls sowie ein Sensorelement zur Verwendung in dem Sensormodul.

## Beschreibung

Die vorliegende Erfindung betrifft ein Sensorelement, ein Sensormodul enthaltend das Sensorelement sowie Verfahren zur Herstellung dieses Sensormoduls.

Sensorelemente, insbesondere Temperatursensoren finden vielfältige Anwendungen von Sensoren für Messungen bei Raumtemperatur z.B. im Haushalt oder zur Überwachung von Motorenwicklungen oder Steckkontakten in Automotive-Anwendungen. Besonders interessant sind Widerstandstemperatursensoren wie zum Beispiel metallbasierte Widerstandstemperatursensoren, da mit ihnen eine hohe Messpräzision erzielt werden kann. Metallbasierte Widerstandstemperatursensoren enthalten einen elektrisch isolierenden Träger, auf dem eine metallische Widerstandsstruktur aufgetragen ist. Die metallische Widerstandsstruktur kann vorzugsweise als Mäanderstruktur ausgebildet sein. An den gegenüberliegenden Enden der Widerstandsstruktur sind üblicher Weise Kontaktpads angeordnet, um die Widerstandsstruktur sicher und beschädigungsfrei kontaktieren zu können. Produktionsbedingt weisen metallbasierte Widerstandstemperatursensoren, insbesondere metallbasierte Sensoren, eine gewissen Schwankung des Widerstands auf. Für viele Anwendungen sind jedoch Widerstandstemperatursensoren notwendig, die möglichst präzise auf einen Nennwert des Widerstands eingestellt sind und eine geringe Schwankung zeigen. Um besonders präzise eingestellte Widerstände zu erzielen, wird üblicher Weise der Widerstand des Sensors im Produktionsprozess etwas niedriger eingestellt als der später geforderte Nennwert. Anschließend wird der Widerstand nachträglich auf den gewünschten Wert eingestellt. Diesen Vorgang nennt man auch Trimmen. Beim Trimmen wird zum Beispiel der Leitungsquerschnitt des Widerstands verringert und dadurch der Widerstand kontrolliert auf den gewünschten Nennwert eingestellt.

Für das Trimmen weist die Widerstandsstruktur typischer Weise eine Trimmstruktur auf, die gezielt dazu eingesetzt wird den Widerstand anzupassen. Es gibt Trimmstrukturen, mit denen der Widerstand schrittweise erhöht werden kann und Trimmstrukturen mit denen der Widerstand der Trimmstruktur, kontinuierlich geändert werden kann. Zum Trimmen werden meist Teile der Trimmstruktur abgetragen, z. B. mit einem Laser. An den Stellen, an denen Teile der Trimmstruktur abgetragen wurden, liegt die Widerstandsstruktur frei. Diese freigelegten Bereiche sind potentielle Eintrittsstellen für Verunreinigungen, die die Widerstandsstruktur negativ beeinflussen können. Deshalb müssen die Trimmstellen nach dem Trimmen verschlossen werden. Dies geschieht im Stand der Technik dadurch, dass eine Abdeckschicht, auch Isolationsschicht oder Passivierungsschicht genannt, auf die Trimmstellen aufgetragen wird. Dies geschieht meist zum Ende des Produktionsprozesses vor der Montage des Sensors zu einem Sensormodul.

Aus dem Stand der Technik sind verschiedene Materialien zum Verschließen der Trimmstellen bekannt, z.B. anorganische Schichten aus Glas oder Keramik oder organischen Polymer wie z.B. Polyimiden. Das Aufbringen einer Abdecksicht auf der Trimmstelle stellt einen zusätzlichen Prozessschritt dar und es wäre wünschenswert, wenn auf diesen Prozessschritt verzichtet werden könnte, um die Produktion der Widerstandstemperatursensoren zu vereinfachen.

Zusätzlich besteht ein Trend zur Miniaturisierung von Sensorelemente, um den Platzbedarf, z.B. auf einer elektronischen Leiterplatte zu verringern. Je kleiner die Sensoren werden, umso enger liegen die Kontaktpads, also die Flächen, über die das Sensorelement zum Auslesen des Signals kontaktiert wird, beieinander. Dies erhöht auch die Gefahr von Kurzschlüssen zwischen den Kontaktpads. Es ist daher wünschenswert Sensorelement bereitzustellen, die mit geringem Platzbedarf montiert werden können, ohne dabei die Kontaktpads kurzzuschließen. Der Trimmprozess findet im Herstellungsprozess üblicher Weise nach der Deposition der ersten Schichten für die Kontaktpads statt. Bei miniaturisierten Sensorelementen ist es schwierig, zielgenau die Trimmstellen mit Polymer zu verschließen, ohne die Kontaktpads zu verunreinigen.

Generell ist es ein Aufgabe der vorliegenden Erfindung, zumindest einen der aus dem Stand der Technik bekannten Nachteile zumindest teilweise zu überwinden.

Eine weitere Aufgabe bestand darin Sensorelemente, insbesondere Widerstandstemperatursensoren mit nahe beieinanderliegenden Kontaktpads, bereitzustellen, die zu miniaturisierten Sensormodulen verarbeitet werden können. Dabei war es eine bevorzugte Aufgabe Kurzschlüsse zwischen benachbarten Kontaktpads zu verhindern.

Eine weitere Aufgabe bestand darin, Sensormodule bereitzustellen, die miniaturisierte Sensorelemente enthalten.

Eine weitere Aufgabe bestand darin, ein vereinfachtes Verfahren zu Herstellung von Sensormodulen bereitzustellen, das insbesondere geeignet ist für miniaturisierte Sensorelemente.

Ein Beitrag zur Lösung mindestens einer der oben genannten Aufgaben wird durch den Gegenstand der unabhängigen Ansprüche bereitgestellt. Die Gegenstände der Unteransprüche stellen bevorzugte Ausführungsformen der Erfindung dar, deren Gegenstand ebenfalls einen Beitrag zur Lösung mindestens eines der oben genannten Gegenstände leistet.

### Begriffsbestimmungen

Raumtemperatur entspricht 20 °C (+293 K). Der Begriff Umgebungsdruck steht für einen Absolutdruck von 1013 hPa.

Die im vorliegenden Zusammenhang genannten Bereiche umfassen die als Grenzwerte angegebenen Werte. So bedeutet eine Angabe der Art "im Bereich von X bis Y" in Bezug auf eine Größe A, dass A die Werte X, Y und Werte zwischen X und Y annehmen kann. Einseitig begrenzte Bereiche der Art "bis Y" für eine Größe A umfassen in analoger Weise den Wert von Y und solche Werte, die kleiner als Y sind.

### Detaillierte Beschreibung

In einem ersten Aspekt betrifft die Erfindung ein Sensorelement, aufweisend
- einen elektrisch isolierenden Träger aufweisend eine erste Seite und eine der ersten Seite gegenüberliegende zweite Seite und
- eine Widerstandsstruktur angeordnet auf der ersten Seite des elektrisch isolierenden Trägers, wobei die Widerstandsstruktur mindestens eine Sensorstruktur, mindestens eine Trimmstruktur und mindestens zwei Kontaktpads enthält,
dadurch gekennzeichnet, dass auf mindestens einem Kontaktpad ein Lotmaterial, insbesondere in Form einer Lotkugel, angeordnet ist.

Sensorelement ist vorzugsweise freistehend und nicht mit weiteren Komponenten, wie z.B. einem Substrat, verbunden, insbesondere nicht über die Kontaktpads unter Verwendung eines Lotmaterials. Das Sensorelement ist vorzugsweise ein Temperatursensorelement, ein Drucksensor oder ein Dehnungsmesselement. Das Temperatursensorelement kann beispielsweise ein NTC- oder ein PTC-Sensorelement sein. Das Messprinzip des Sensorelements kann auf metallischer Leitung beruhen. Besonders bevorzugt ist das Sensorelement ein Widerstandssensor, ganz bevorzugt ein Widerstandstemperatursensor *(RTD, engl. resistance temperature detector*)*.*

Vorzugsweise ist das Sensorelement ein oberflächenmontierbares Bauteil (SMD, surface mounted device), das ohne Verwendung von Drähten und Kabeln direkt auf Leiterstrukturen auf einem Substrat angeordnet werden kann. Das Sensorelement umfasst vorzugsweise mindestens eine Widerstandsstruktur auf einem elektrisch isolierenden Träger. Die Widerstandsstruktur ist vorzugsweise eine metallische Widerstandsstruktur. Dabei umfasst die Widerstandsstruktur insbesondere mindestens eine Sensorstruktur und optional mindestens zwei Kontaktpads und ebenfalls optional mindestens eine Trimmstruktur.

Das Sensorelement weist vorzugsweise eine Dicke von höchstens 200 µm auf, insbesondere von höchstens 100 µm und ganz besonders bevorzugt von höchstens 50 µm. Die Höhe wird vorzugsweise senkrecht zur Oberfläche gemessen, auf der die Sensorstruktur angeordnet ist. Vorzugsweise überschreitet das Sensorelement in keiner Dimension eine Ausdehnung von 1 mm, insbesondere von 600 µm. Die Oberfläche des Sensorelements, auf der die Sensorstruktur angeordnet ist, weist vorzugsweise eine Fläche von höchstens 1 mm² auf.

In einer besonders bevorzugten Ausführung kann das Sensorelement ein Sensor sein, wie er in WO2021047948A1 beschrieben ist, insbesondere in Form eines Temperatursensors. Besonders bevorzugt ist das Sensorelement ein Sensor, wie er in den Figuren 1 und 2 der WO2021047948A1 mit der dazugehörigen Beschreibung offenbart ist.

Das Sensorelement weist bevorzugt einen Widerstands-Temperaturkoeffizienten von mindestens 0,003 K⁻¹, insbesondere von mindestens 0,0035 K⁻¹ im Bereich von -50°C - 200 °C auf.

Das Sensorelement enthält einen elektrisch isolierenden Träger. Bevorzugt ist der elektrisch isolierende Träger ausgebildet, um elektrisch leitende Strukturen darauf auszubilden. Der elektrisch isolierende Träger weist vorzugsweise eine erste Seite und eine der ersten Seite gegenüberliegende zweite Seite auf. Insbesondere sind die erste und die zweite Seite planparallel zueinander. Alternativ kann der elektrisch isolierende Träger auch gebogen sein. Die erste Seite des elektrisch isolierenden Trägers stellt vorzugsweise auch die erste Seite des Sensorelements dar. Der elektrisch isolierende Träger kann eine Scheibe oder eine Platte sein. In einer Ausführungsform hat der elektrisch isolierende Träger die Form eines Quaders.

In einer bevorzugten Ausführungsform ist zumindest eine erste Seite des Trägers ist elektrisch isolierend. In einer bevorzugten Ausführungsform weist die erste Seite des elektrisch isolierenden Trägers ein dielektrisches Material auf. In einer möglichen Ausführung der Erfindung weist das dielektrische Material die Form einer Schicht, insbesondere einer vollflächigen Schicht, auf. Das dielektrische Material kann ausgewählt sein aus der Gruppe enthaltend Gläser, Keramiken, Glaskeramiken und Polymere. Die Gläser können beispielsweise ausgewählt sein aus Oxidgläsern, wie z.B. Silikatgläser, Borosilikatgläsern, Alumosilikatgläser und Bleigläser. Die Keramik des dielektrischen Materials kann ausgewählt sein aus der Gruppe enthaltend Oxidkeramiken, Carbidkeramiken, Nitridkeramiken, Mischkeramiken der vorgenannten Keramiken. Die Oxidkeramiken des dielektrischen Materials können beispielsweise Siliziumoxid, Aluminiumoxid, Titanoxid und Zirkonoxid sowie Mischungen dieser Oxide beinhalten oder daraus bestehen. Die Polymere können beispielsweise Polyimide oder Parylene umfassen.

Das dielektrische Material kann eine oder mehreren Schichten aufweisen. Beispielsweise kann das dielektrische Material eine Kombination einer Oxidkeramikschicht mit einer Nitridkeramikschicht enthalten. Vorzugsweise weist der elektrisch isolierende Träger auf der ersten und der zweiten Seite ein dielektrisches Material auf. Insbesondere weist der elektrisch isolierende Träger auf allen Seiten, auf denen leitfähige Strukturen angeordnet sind, ein dielektrisches Material auf. In einer möglichen Ausgestaltung der Erfindung kann das dielektrische Material, insbesondere in Form einer Schicht, auf einem leitfähigen Material angeordnet sein. Das leitfähige Material kann optional als Schicht ausgestaltet sein. Das leitfähige Material kann zum Beispiel ausgewählt sein aus der Gruppe umfassend Halbleiter, dotierte Halbleiter und Metalle. Der Halbleiter kann z.B. ein Siliziumwafer sein. Das dotierte Halbleitermaterial kann z.B. ein Bor-dotierter Siliziumwafer sein. Das Metall des leitfähigen Materials kann z.B. eine Metallfolie oder ein Metallblech sein. Das Metall kann z.B. ausgewählt sein aus der Gruppe umfassend Stahl, insbesondere Aluminium-haltigen Stahl, Chrom-haltigen Stahl, Nickellegierungen und Kupfer.

In einer alternativen Ausführung besteht der elektrisch isolierende Träger aus einem oder mehreren dielektrischen Materialien. In einer anderen möglichen Ausführungsform weist die zweite Seite des elektrisch isolierenden Trägers ebenfalls ein dielektrisches Material auf. Das dielektrische Material auf der zweiten Seite kann gleich oder verschieden sein von dem dielektrischen Material der ersten Seite.

Optional kann der elektrisch isolierende Träger starr oder flexibel sein. Wenn der elektrisch isolierende Träger flexibel ist, weist auch das Sensorelement vorzugsweise eine Flexibilität auf. Ein flexibler elektrisch isolierender Träger hat den Vorteil, dass er auftretende mechanische Spannungen besser ausgleichen kann als ein starrer Träger. In einer bevorzugten Ausführungsform weist das Sensorelement eine Flexibilität auf, die mit einem Biegekrümmungsradius von mindestens 5 mm, vorzugsweise mindestens 2 mm, vorzugsweise mindestens 1 mm, biegbar ist, wobei eine relative Differenz des spezifischen Widerstands (d R/R(0), wobei d Delta oder Δ bedeutet) der Widerstandsstruktur vor und nach dem Biegen vorzugsweise 2% , insbesondere 1% und ganz besonders bevorzugt 0,5 % nicht überschreiten darf. Nach dem Biegen meint hier insbesondere, dass das Sensorelement wieder in seinen Ausgangszustand zurückgekehrt ist.

Eine solche Flexibilität des Sensorelements kann wie folgt gemessen werden. Das Sensorelement wird planparallel auf eine Polyimidfolie (Kapton^{®}, 25 µm) geklebt, um die Flexibilität des Sensorelements zu bestimmen. Vor dem Aufkleben wird die Oberfläche der Kapton-Folie durch Behandlung mit einer Koronaentladung aktiviert. Ein Klebstoff auf Cyanobasis (MINEA, Sekundenkleber) wird auf die Rückseite des Sensorelements aufgetragen und das Sensorelement für die Reaktionszeit des Klebstoffs auf die Polyimidfolie gedrückt. Anschließend wird die Polyimidfolie um einen zylindrischen Stab gewickelt, wobei das Sensorelement nach außen gerichtet ist. Der Durchmesser des Stabes wird im Bereich von 0,25 mm bis 10 mm gewählt. Beim Umwickeln ist die Polyimidfolie in engem Kontakt mit der Oberfläche des zylindrischen Stabes. Daher beträgt der Krümmungsradius des Sensorelements ungefähr die Hälfte des Durchmessers des Stabes. Die Dauer der maximalen Biegung wird auf etwa eine Sekunde festgelegt. Die relative Differenz des spezifischen Widerstands dR/R(0) (wobei d delta oder Δ bedeutet) der elektrischen Struktur wird vor und nach jedem Biegezyklus gemessen. Das Sensorelement kann als flexibel gelten, solange der Krümmungsradius nicht kleiner als der Mindestradius Rm ist. Rm ist definiert als der Radius, bei dem d R/R(0) höchstens 2%, insbesondere höchstens 1% und ganz besonders bevorzugt höchstens 0,5 % ist. Rm kann beispielsweise im Bereich von 0,1 bis 0,5 cm liegen.

Auf dem elektrisch isolierenden Träger ist eine Widerstandsstruktur angeordnet. Die Widerstandsstruktur ist vorzugsweise auf der ersten Seite des elektrisch isolierenden Trägers angeordnet. Die Widerstandsstruktur kann ein Metall aufweisen oder daraus bestehen. Das Metall kann vorzugsweise ausgewählt sein aus der Gruppe enthaltend Platin, Nickel, Aluminium, Palladium, Gold, Silber und Kupfer, sowie Legierungen, die mindestens eines dieser Metalle als Hauptkomponente enthalten. Unter der Hauptkomponente kann das Element verstanden werden, dass in der Legierung den höchsten Gewichtsanteil hat. Weiter bevorzugt kann die Legierung Rhodium, Kupfer, Platin, Nickel, Aluminium, Palladium, Gold, Silber und Kupfer als mindestens eines der weiteren Legierungselemente enthalten.

In einer möglichen Ausführung umfasst die Widerstandsstruktur ein Schichtsystem aus mehreren leitenden Schichten. Zum Beispiel kann die Widerstandsstruktur ein metallisches Schichtsystem aufweisen. In einem Schichtsystem können unterschiedliche Schichten unterschiedliche Aufgaben übernehmen, z.B. kann eine Schicht für eine besonders gute Anbindung sorgen, während eine weitere Schicht maßgeblich für eine gute elektrische Leitung verantwortlich ist.

Alternativ oder auch zusätzlich enthält die Widerstandsstruktur eine leitfähige Keramik oder einen leitfähigen Halbleiter. In einer möglichen Ausführungsform wird die Widerstandsstruktur hergestellt aus einer flächigen Schicht, insbesondere einer Metallschicht, die anschließend zur Widerstandsstruktur mit der gewünschten Form strukturiert wird. Das Strukturieren kann beispielsweise durch Ablationsverfahren erfolgen.

Im Prinzip kann die Widerstandsstruktur in jeder beliebigen Form strukturiert werden, die die Verwendung als Widerstandstemperatursensor erlaubt. Das Strukturieren kann insbesondere mittels Lithografie oder mittels Ablationsverfahren, z.B. Laserablationsverfahren erfolgen.

Die Widerstandsstruktur weist mindestens eine Sensorstruktur, vorzugsweise mindestens eine Trimmstruktur und vorzugsweise mindestens zwei Kontaktpads auf. In einer besonders bevorzugten Ausführung weist die Widerstandsstruktur mindestens zwei räumlich getrennte Trimmstrukturen auf, die auf der ersten Seite des elektrisch isolierenden Trägers, beispielsweise entlang von gegenüberliegenden Kanten angeordnet sind.

Die Sensorstruktur ist vorzugsweise derart ausgeführt, dass Sie eine messbare Änderung des elektrischen Widerstands in Abhängigkeit einer physikalischen Größe wie der Temperatur aufweist. Bevorzugt kann die Sensorstruktur eine Mäanderform aufweisen, insbesondere dann, wenn die Sensorstruktur zur Temperaturmessung verwendet wird. Alternativ kann die Sensorstruktur jede mögliche Geometrie aufweisen, die dem Fachmann für Sensortechnik zweckmäßig erscheint.

Die mindestens eine Trimmstruktur der Widerstandsstruktur ist vorzugsweise eine leitfähige Struktur, deren Widerstand durch Materialmanipulation verändert, insbesondere erhöht, werden kann. Insbesondere kann die Trimmstruktur so manipuliert werden, dass der Widerstand der gesamten Widerstandsstruktur enthaltend die Trimmstruktur einem festgelegten Nennwiderstand entspricht. Insbesondere kann die Materialmanipulation durch ein Ablationsverfahren erfolgen. Das Ablationsverfahren kann vorzugsweise mit einem Verfahren erfolgen, das ausgewählt ist aus Ätzen, Fräsen, Schleifen und Laserablation. Wenn im Rahmen der Erfindung von einem Nennwiderstand die Rede ist, ist für den Fachmann ersichtlich, dass der tatsächliche Widerstand in einem Toleranzbereich um den Nennwiderstand schwankt. Zum Beispiel können für Platin-Widerstandsstrukturen die Toleranzbereiche in einer Norm, z.B. einer DIN-Norm spezifiziert sein. Vorzugsweise ist die Trimmstruktur parallel oder in Reihe mit den restlichen Teilen der Widerstandsstruktur geschaltet.

Die mindestens eine Trimmstruktur kann so gestaltet sein, dass deren Widerstand stufenweise oder kontinuierlich verändert werden kann. Ein stufenweiser Trimm kann auch als Digitaltrimm bezeichnet werden und ein kontinuierlicher Trimm als Analogtrimm. Eine Struktur, die eine stufenweise Anpassung des Widerstands erlaubt, ist zum Beispiel eine in zwei oder mehr parallellaufende Einzelstränge aufgeteilte Leiterbahnstruktur, die so bearbeitet werden kann, dass einzelne der parallellaufenden Leiterbahnen aufgetrennt werden können, wodurch sich der Leitungsquerschnitt verringert. Eine Struktur, die einen kontinuierliche Anpassung des Widerstands erlaubt, kann beispielsweise ein Streifen sein, der so bearbeitet werden kann, dass sich die Strecke, die der elektrische Strom durchfließen muss, kontinuierlich verlängert, z.B. indem ein Schlitz in den Streifen hineingeschnitten wird. Optional kann die Widerstandsstruktur mehrere Trimmstrukturen aufweisen, z.B. eine für einen Analogtrimm und einen für einen Digitaltrimm. Bei dem erfindungsgemäßen Sensorelement weist die mindestens eine Trimmstruktur mindestens einen Bereich auf, in dem ein Teil der Trimmstruktur durchtrennt ist oder in dem Material teilweise abgetragen ist. Dieser Bereich, in dem Material abgetragen ist wird auch Trimmstelle genannt.

Weiterhin enthält die Widerstandsstruktur mindestens zwei Kontaktpads. Als Kontaktpads können Flächen der Widerstandsstruktur verstanden werden, die dazu geeignet sind, einen elektrischen und mechanische Kontakt herzustellen, beispielsweise zu elektrischen Leitungen oder Drähten. Die Kontaktpads können dazu ausgebildet sein darauf Drähte oder Bändchen zu bonden, zu schweißen oder zu löten. Die Sensorstruktur erstreckt sich vorzugsweise von einem ersten Kontaktpad zu mindestens einem weiteren Kontaktpad. Jedes der mindestens zwei Kontaktpads kann vorzugsweise jeweils bis zu 25% oder besonders bevorzugt bis zu 10% der Fläche der ersten Seite des isolierenden Trägers einnehmen. Die Kontaktpads können beispielsweise an gegenüberliegenden Enden des isolierenden Trägers angeordnet sein oder am gleichen Ende. Größere Kontaktpads haben den Vorteil, dass sie leichter kontaktierbar sind. Die Dicke der Kontaktpads auf dem elektrisch isolierenden Träger liegt vorzugsweise im Bereich von 200 nm bis 5 µm, insbesondere im Bereich von 500 nm bis 1 µm.

Vorzugsweise ist die Widerstandsstruktur aus einem Stück ausgebildet, das heißt die Sensorstruktur, die mindestens eine Trimmstruktur und die mindestens zwei Kontaktpads werden zusammen hergestellt. Beispielsweise können alle drei Teile der Widerstandsstruktur aus einer durchgängigen Schicht, insbesondere einer Metallschicht, durch Strukturieren hergestellt sein. Alternativ kann die Widerstandsstruktur gedruckt werden, z.B. mittels Tintenstrahldruck.

In einer anderen Ausführungsform werden die Kontaktpads getrennt von Sensorstruktur und / oder der Trimmstruktur hergestellt. Beispielsweise können die Kontaktpads auf die gegenüberliegenden Enden der Sensorstruktur gedruckt sein, z.B. mit Dickschichtverfahren. Dabei enthalten die Kontaktpads vorzugsweise das gleiche Metall wie die Sensorstruktur oder ein Metall, das von dem der Sensorstruktur verschieden ist. Zusätzlich können die Geometrien und/oder Größen der unter den Kontaktpads liegenden Sensorstruktur und die Geometrien und/oder Größen der Kontaktpads voneinander abweichen.

In einer besonders bevorzugten Ausführung weist mindestens ein Kontaktpad mindestens ein Kontaktpatch auf, wobei das Kontaktpatch elektrisch mit dem Kontaktpad verbunden ist. Ein Kontaktpatch kann vollflächig auf einem Kontaktpad angeordnet sein oder nur einen Teil eines Kontaktpads bedecken.

Als Kontaktpatch kann vorzugsweise eine einteilige oder mehrteilige Metallschicht auf einem Kontaktpad verstanden werden. Vorzugsweise dient das Kontaktpatch dazu die Kontaktierbarkeit des Kontaktpads zu verbessern. Insbesondere kann ein Kontaktpatch die Lötbarkeit und Bondbarkeit verbessern. Weiterhin kann ein Kontaktpatch die Dicke der Kontaktpads erhöhen und somit das darunter befindliche Kontaktpad vor mechanischer Beschädigung schützen.

Ein Kontaktpatch kann beispielsweise Nickel oder eine Nickel-Legierung aufweisen. Ein Kontaktpatch kann in einer Ausführung aus mindestens zwei oder mehr übereinander abgeschiedenen Schichten bestehen. In einer Ausführung kann ein Kontaktpatch Nickel und Gold aufweisen. Vorzugsweise weist ein Kontaktpad mehrere Kontaktpatches auf. Beispielsweise können auf einem Kontaktpad zwei, vier, sechs, acht, zehn , zwölf, vierzehn oder sechzehn Kontaktpatches vorliegen.

Ein Kontaktpatch nimmt bevorzugt weniger als 10% der Fläche der ersten Seite des Sensorelements ein. Ein Kontaktpatch nimmt weiterhin bevorzugt weniger als 40% der Fläche der ersten Seite des Kontaktpads ein, noch mehr bevorzugt weniger als 25%. Für die Bestimmung der Fläche der Kontaktpatches ist vorzugsweise die Projektion des Kontaktpatches auf das Kontaktpad in der Draufsicht senkrecht zur ersten Seite des elektrisch isolierenden Trägers heranzuziehen.

Kontaktpatches sind vorzugsweise erhabene, räumlich begrenzte Metallschichten (auch Flecken genannt), die zur verbesserten elektrischen und mechanischen Kontaktierung des Kontaktpads ausgebildet sein können, und auf den Kontaktpads angeordnet sind. Vorzugsweise sind sie direkt auf der Oberfläche eines Kontaktpads angeordnet. Kontaktpatches können beispielsweise durch galvanische Verfahren wie elektrochemische (ECD) und stromlose (ELD) Abscheidung von Metallen auf Kontaktpads hergestellt werden. Kontaktpatches können optional auch in einem Dickschichtverfahren, z.B. einem Druckverfahren, insbesondere einem Siebdruckverfahren, hergestellt werden. Optional können die Kontaktpatches ein anderes Metall oder eine andere Legierung als die darunterliegenden Kontaktpads enthalten.

Für den Fall, dass auf den Kontaktpads eine Isolierschicht vorliegt, kann die Isolierschicht vor der Metallabscheidung punktuell entfernt werden, etwa mit einem Laser, und an den freigelegten Stellen können dann Kontaktpatches mittels der oben genannten galvanischen Abscheideverfahren aufgebracht werden. Auch galvanische hergestellte Schichtsysteme sind möglich. Weitere mögliche Verfahren zur Herstellung der Kontaktpatches sind beispielsweise Siebdruck oder Tampondruck.

Die Dicke eines Kontaktpatches liegt vorzugsweise im Bereich von 5 µm bis 20 µm und insbesondere im Bereich von 10 µm - 15 µm. In einer bevorzugten Ausführungsform ragen die Kontaktpatches vorzugsweise 5 µm bis 20 µm, insbesondere 5 µm bis 10 µm über eine optional vorliegende Isolierschicht hinaus.

Vorteilhaft weist ein Kontaktpatch eine Fläche von 0,01 mm² oder weniger, insbesondere 0,005 mm² oder weniger auf. Der Querschnitt eines Kontaktpatches in einer Ebene parallel zum Träger kann bevorzugt im Bereich von 10 µm bis 100 µm liegen. Weiterhin kann der Abstand zweier benachbarten Patches auf einem Kontaktpad von Kante zu Kante im Bereich von 1 µm bis 300 µm liegen. In einer bevorzugten Ausführungsform ist der maximale Querschnitt eines Kontaktpatches in einer Ebene parallel zum Träger größer als die darunterliegende kontaktierte Fläche, des Kontaktpads. Bevorzugt ragen die Kontaktpatches über die Isolierschicht oder anders ausgedrückt können die Kontaktpatches eine Art Pilzform aufweisen. Alternativ können die Kontaktpatches einen konstanten Durchmesser aufweisen, beziehungsweise nicht nach oben hin breiter werden.

Auf mindestens einem Kontaktpad ist vorzugsweise ein Lotmaterial, angeordnet. Vorzugsweise ist auf dem Kontaktpad mindestens ein Kontaktpatch ausgebildet, wenn auf dem Kontaktpad ein Lotmaterial angeordnet ist. Ganz besonders bevorzugt ist zwischen dem Kontaktpad und dem Lotmaterial mindestens ein Kontaktpatch angeordnet, wie es hierin beschrieben ist. Vorzugsweise enthält das Lotmaterial eine Lotlegierung oder es besteht aus einer Lotlegierung. Zusätzlich umfasst das Lotmaterial bevorzugt mindestens ein Flussmittel.

Lotlegierungen sind dem Fachmann für Aufbau- und Verbindungstechnik in der Elektronik bekannt und können nach Bedarf ausgewählt werden. Übliche Lotlegierungen können ausgewählt sein aus der Gruppe enthaltend bleihaltige und bleifrei Legierungen. Typische Lotlegierungen enthalten mindestens ein Metall ausgewählt aus der Gruppe enthaltend Zinn, Zink, Silber und Kupfer. Geeignete Lotlegierungen sind dem Fachmann für Aufbau- und Verbindungstechnik bekannt und können je nach Anwendung ausgewählt werden.

In einer Ausführungsform ist das Lotmaterial eine Lotpaste. Eine Lotpaste enthält mindestens eine Lotlegierung sowie ein Vehikel. Bevorzugt liegt die Lotlegierung in Form von Partikeln vor. Das Vehikel kann ein organisches Vehikel oder ein wässriges Vehikel sein. Vorzugsweise enthält das Vehikel mindestens ein Lösungsmittel. Zusätzlich kann das Vehikel ein oder mehrere weitere Bestandteile umfasse, wie z.B. Flussmittel, Additive, Rheologievermittler, Thixotropiemittel und Stabilisatoren.

Lotmaterial ist vorzugsweise eine Lotpaste, enthaltend Lotlegierung. Die Lotpaste kann weitere Bestandteile enthalten, wie z.B. Additive, Flussmittel, Rheologievermittler, Lösungsmittel, etc.. Geeignete Lotpasten sind dem Fachmann für Aufbau- und Verbindungstechnik bekannt. Lotpasten können beispielsweise mittels Dispensens oder Druckens auf mindestens einem Kontaktpad aufgebracht werden.

In einer weiteren bevorzugten Ausführung kann das Lotmaterial in Form einer Lotkugel (*engl. Solder Ball*) vorliegen. Eine Lotkugel umfasst vorzugsweise eine Lotlegierung. Eine Lotkugel kann erzeugt werden durch Aufschmelzen einer Lotpaste und anschließendes Erstarren lassen. Durch das Aufschmelzen der Lotlegierung wird diese flüssig und bildet aufgrund der Oberflächenspannung einen kugelförmigen Tropfen. Beim Erstarren bleibt die Kugelform weitestgehend erhalten. In einer bevorzugten Ausführung der Erfindung weist jedes Kontaktpad des Sensorelements ein Lotmaterial, insbesondere eine Lotkugel (eng. *solder ball*), auf.

Bevorzugt ist die Widerstandsstruktur zumindest im Bereich außerhalb der Trimmstruktur mit einer Isolierschicht bedeckt. Insbesondere ist die Sensorstruktur der Widerstandsstruktur mit einer Isolierschicht bedeckt. Die Isolierschicht kann direkt auf der Widerstandsstruktur angeordnet sein oder indirekt. Wenn die Isolierschicht indirekt auf der Widerstandsstruktur angeordnet ist, kann die Widerstandsstruktur zum Beispiel mit einer ersten anorganische Passivierungsschicht passiviert sein. In einer bevorzugten Ausführungsform bedeckt die Isolierschicht die Trimmstruktur und die Kontaktpads zumindest teilweise nicht. Insbesondere bedeckt die Isolierschicht die Trimmstruktur dort nicht, wo getrimmt werden soll oder getrimmt wurde. Weiterhin bedeckt die Isolierschicht die Kontaktpads insbesondere dort nicht, wo Kontaktpatches angeordnet sind oder angeordnet werden. Die Bereiche, in denen die Isolierschicht die Widerstandsstruktur nicht bedeckt, können auch als Fenster oder Öffnungen in der Isolierschicht ausgebildet sein. Optional kann die Isolierschicht als flächige Schicht aufgetragen werden, und anschließend die Bereiche über der Trimmstruktur und / oder den Kontaktpads wieder entfernt werden. Das Auftragen der flächigen Schicht kann beispielsweise durch Spin-Coating erfolgen. Das Entfernen kann z.B. mit Hilfe eines Lasers erfolgen.

Vorzugsweise enthält die Isolierschicht ein dielektrisches Material, das ausgewählt ist aus der Gruppe bestehend aus Polymeren, Gläsern, Keramiken und Glaskeramiken. Für den Fall, dass die Isolierschicht ein Polymer enthält oder daraus besteht, kann die Isolierschicht mittels Spin-Coating aufgebracht werden. Polymere als Material der Isolierschicht habe den Vorteil, dass sie leicht verarbeitet werden können und nicht bei hohen Temperaturen eingebrannt werden müssen.

Die Oberfläche der Widerstandsstruktur des Sensorelements ist vorzugsweise zumindest teilweise mit einer ersten anorganischen Passivierungsschicht beschichtet. Die erste anorganische Passivierungsschicht liegt vorzugsweise nicht auf den Kontaktpads vor, insbesondere nicht dort, wo die Kontaktpads Kontaktpatches aufweisen. Optional kann sich die erste anorganische Passivierungsschicht auch auf weitere Bereiche der ersten Seite des elektrisch isolierenden Trägers erstrecken.

Die erste anorganische Passivierungsschicht weist vorzugsweise mindestens ein Metalloxid, ein Metallnitrid oder eine Metalloxid-Nitrid-Kompositmaterial auf. Das Metalloxid kann z.B. Siliziumoxid, Aluminiumoxid oder Titanoxid aufweisen. Das Metallnitrid kann beispielsweise Siliziumnitrid, Titannitrid, oder Aluminiumnitrid sein. Das Kompositmaterial kann beispielsweise ein Schichtmaterial aus mindestens einer Metalloxidschicht und mindestens einer Metallnitridschicht umfassen. Optional können in einem Kompositmaterial auch mehrere unterschiedliche Oxide oder mehrere unterschiedliche Nitride verwendet werden, z.B. zur Verbesserung der Diffusionssperrwirkung. Die Dicke der ersten anorganischen Passivierungsschicht liegt vorzugsweise im Bereich von 200 nm bis 1,5 µm.

In einer möglichen Ausgestaltung der Erfindung ist die Trimmstruktur nicht von mindestens einer weiteren Passivierungsschicht oder einer Abdeckschicht zumindest teilweise bedeckt.

Vorzugsweise handelt es sich bei dem Sensorelement um ein Sensorelement, dass nicht, bzw. noch nicht auf einem Substrat angeordnet ist. Mit anderen Worten kann Sensorelement auch als Sensorelement mit vorappliziertem Lotmaterial auf den Kontaktpads verstanden werden.

Im Rahmen der Erfindung kann das Sensorelement beispielsweise mit einem Verfahren hergestellt werden, das die folgenden Schritte enthält:
- Bereitstellen eines elektrisch isolierenden Trägers.
- Aufbringen einer leitfähigen Schicht, insbesondere einer Metallschicht mittels bekannter Dünn- oder Dickschichtverfahren,
- Strukturieren der leitfähigen Schicht unter Erhalt einer Widerstandsstruktur umfassend eine Sensorstruktur, mindestens eine Trimmstruktur mindestens zwei Kontaktpads,
- optional Passivieren der Widerstandsstruktur mit einer ersten anorganischen Passivierungsschicht,
- optional, Bedecken der Widerstandsstruktur mit einer Isolierschicht, wobei die Isolierschicht die Trimmstruktur zumindest teilweise nicht bedeckt und
- Trimmen der Widerstandsstruktur über die Trimmstruktur auf einen Nennwiderstand,
- Optional können Kontaktpatches auf die Kontaktpads aufgetragen werden, z.B. mit galvanischen Verfahren, und
- Aufbringen eines Lotmaterials auf mindestens eine Kontaktpad, insbesondere ein Kontaktpad enthaltend mindestens ein Kontaktpatch.

Das verwendete Dünnschichtverfahren kann in einem Beispiel ausgewählt sein aus chemischer oder physikalischer Gasphasenabscheidung (CVD bzw. PVD) und Sputtering. Das Dickschichtverfahren kann zum Beispiel ein Druckverfahren wie z.B. ein Siebdruckverfahren sein. Das Strukturieren der leitfähigen Schicht kann durch lithografische Verfahren oder mittels Ablationsverfahren wie z.B. Laserablation erfolgen.

In einem zweiten Aspekt betrifft die Erfindung ein Sensormodul aufweisend
- einen Sensorelement, insbesondere wie es hierin beschrieben ist, umfassend einen elektrisch isolierenden Träger aufweisend eine erste Seite und eine der ersten Seite gegenüberliegende zweite Seite, wobei eine Widerstandsstruktur auf der ersten Seite des isolierenden Trägers angeordnet ist und wobei die Widerstandsstruktur mindestens eine Sensorstruktur, mindestens eine Trimmstruktur und mindestens zwei Kontaktpads enthält, und
- ein Substrat aufweisend eine erste Oberfläche mit darauf angeordneten Leiterstrukturen,
wobei das Sensorelement mit der ersten Seite des isolierenden Trägers zur ersten Oberfläche des Substrats hin angeordnet ist, dadurch gekennzeichnet, dass zwischen mindestens einem Kontaktpad des Sensorelements und mindestens einer Leiterstruktur des Substrats eine Lotverbindung ausgebildet ist und dass zwischen dem Sensorelement und dem Substrat zumindest ein polymeres Isolationsmaterial vorliegt und bevorzugt mindestens die Trimmstruktur bedeckt.

Die Merkmale des Sensorelements gemäß dem ersten Aspekt der Erfindung können bevorzugt und wo anwendbar auch für das erfindungsgemäße Sensormodul gelten. Unter einem Sensormodul kann eine Vorrichtung verstanden werden, bei der ein Sensorelement, insbesondere ein erfindungsgemäßes Sensorelement, auf einem Substrat angeordnet ist. Insbesondere kann das Substrat zur elektrischen Kontaktierung des Sensorelements ausgebildet sein. Die elektrische Kontaktierung des Sensorelements kann durch Leiterstrukturen erfolgen. Das Sensorelement kann insbesondere ein Sensorelement sein, wie es hierin beschrieben ist. Das Sensorelement kann, z.B. ein NTC- oder ein PTC-Sensorelement sein.

Besonders bevorzugt umfasst das Sensormodul ein Sensorelement, wobei das Sensorelement eine Trimmstelle aufweist. Weiterhin bevorzugt umfasst das Sensorelement eine Trimmstelle, die nach dem Trimmen zumindest nicht vollständig abgedeckt ist. Ganz besonders bevorzugt wurde die Trimmstelle nach dem Trimmen nicht weiter verändert, bevor das Sensorelement zu einem Sensormodul verarbeitet wird.

Besonders bevorzugt ist das Sensorelement sehr klein und weist in keiner Dimension eine Ausdehnung von mehr als einem Millimeter auf. Insbesondere weist die erste Seite des Sensorelements eine Fläche auf, die höchstens 1 mm² beträgt.

Das Substrat weist eine erste Oberfläche mit darauf angeordneten Leiterstrukturen auf. Das Substrat ist vorzugsweise elektrisch isolierend. Die Leiterstrukturen können beispielsweise ein Metall aufweisen oder daraus bestehen. Das Metall kann beispielsweise ausgewählt sein aus der Gruppe enthaltend Gold, Silber und Kupfer. Alternative können auch andere elektrisch leitfähige Materialien für die Leiterstrukturen verwendet werden. Zum Beispiel kann das Substrat eine Leiterplatte sein, insbesondere eine gedruckte Leiterplatte (engl. *printed circuit board,* PCB) oder ein *metal-ceramic-substrate* (MCS), wie z.B. ein DCB-Substrat.

Erfindungsgemäß ist zwischen mindestens einem Kontaktpad des Sensorelements und mindestens einer Leiterstruktur des Substrats eine Lotverbindung ausgebildet. In einer bevorzugten Ausführung ist zwischen jedem Kontaktpad des Sensorelements und einer oder mehrere Leiterstrukturen des Substrats eine Lotverbindung ausgebildet.

Optional ist auf jedem Kontaktpad jeweils mindestens ein Kontaktpatch angeordnet, wie es hierin beschrieben ist. Ebenfalls optional können auf einem Kontaktpad mindestens zwei räumlich getrennte Kontaktpatches angeordnet sein. In einer Ausführung entspricht die Anzahl der Kontaktpatches auf den Kontaktpads mindestens der Zahl der zu kontaktierenden Leiterstrukturen auf dem Substrat. Die Kontaktierung erfolgt bevorzugt über Lotverbindungen.

In einer Ausführung können alle Kontaktpatches auf einem Kontaktpad dieselbe Leiterstruktur kontaktieren. Alternativ können mindestens zwei Kontaktpatches auf einem Kontaktpad von unterschiedlichen Leiterstrukturen kontaktiert werden.

In einer besonders bevorzugten Ausführungsform der Erfindung sind auf jedem Kontaktpad mindestens zwei Kontaktpatches angeordnet, wobei mindestens zwei Kontaktpatches auf demselben Kontaktpad von unterschiedlichen Leiterstrukturen kontaktiert werden. In dieser Ausführungsform kann vorzugsweise eine Vierleiter-Messkonfiguration verwirklicht werden, wie sie dem Fachmann bekannt ist. Vierleitermessungen haben den Vorteil, dass die Leitungs- und Anschlusswiderstände die Messung des Widerstands nicht verfälschen können.

Weiterhin bevorzugt können auf einem Kontaktpad mindestens zwei Kontaktpatches angeordnet sein, wobei mindestens eines der Kontaktpatches keinen elektrischen Kontakt zu einer Leiterstruktur auf dem Substrat aufweist.

Das ist Sensorelement mit der ersten Seite des isolierenden Trägers hin zur ersten Oberfläche des Substrats angeordnet. Dies kann auch als face-down-Konfiguration bezeichnet werden.

Zwischen mindestens einem Kontaktpad des Sensorelements und mindestens einer Leiterstruktur des Substrats ist eine Lotverbindung ausgebildet. Die Lotverbindung kann stellt vorzugsweise einen elektrischen Kontakt zwischen den Kontaktpads der Widerstandsstruktur und der Leiterstruktur auf dem Substrat her und sorgt für eine mechanische Befestigung des Sensorelements auf dem Substrat.

Wenn das Sensorelement auf dem Substrat angeordnet ist und eine oder mehrere Lotverbindungen ausgebildet sind, kann zwischen dem Sensorelement und dem Substrat ein Zwischenraum gebildet sein. Zwischen dem Sensorelement und dem Substrat liegt zumindest ein polymeres Isolationsmaterial vor, insbesondere in dem gebildeten Zwischenraum. Ein polymeres Isolationsmaterial enthält ein Polymer oder es besteht daraus. Das polymer Isolationsmaterial kann in einem Beispiel ausgewählt sein aus Epoxidharzen oder Silikonen. Besonders bevorzugt ist das polymere Isolationsmaterial ein vernetztes Epoxidharz. In einer möglichen Ausführung enthält das polymere Isolationsmaterial einen Füllstoff, insbesondere einen anorganischen Füllstoff, wie z. B. Glaspulver oder Keramikpulver. Füllstoffe können die thermische Leitfähigkeit verbessern oder die Materialschrumpfung beim Aushärten einer polymeren Komponente reduzieren.

Vorzugsweise bedeckt das polymere Isolationsmaterial mindestens die mindestens eine Trimmstruktur der Widerstandsstruktur, insbesondere bedeckt es eine oder mehrere Trimmstellen. Vorzugsweise verschließt das polymere Isolationsmaterial die mindestens eine Trimmstruktur und ganz besonders bevorzugt damit auch eine oder mehrere Trimmstellen. Dadurch kann die Widerstandsstruktur, insbesondere die Trimmstruktur mit Trimmstellen, wirksam vor Umwelteinflüssen wie Feuchtigkeit, korrosiven Substanzen oder Fremdatome geschützt werden.

Dadurch, dass das polymere Isolationsmaterial, das im Zuge des Herstellungsprozesses zwischen Sensorelement und Substrat angeordnet wird, die Trimmstrukturen und insbesondere eine oder mehrere Trimmstellen verschließt, kann auf die separate Herstellung einer Deckschicht über der Trimmstruktur während des Herstellungsprozesses des Sensorelements verzichtet werden.

Bevorzugt kann das polymere Isolationsmaterial ein Underfill-Material sein, insbesondere ein Underfill-Material, wie es in der Elektronikindustrie verwendet wird. Das polymere Isolationsmaterial kann ein Kapillar-Underfill oder ein No-flow-Underfill sein. Ein Kapillar-Underfill wird als Flüssigkeit am Rand des Zwischenraums zwischen Sensorelement und Substrat aufgebracht, wobei die Flüssigkeit auf Grund von Kapillarkräften in den gebildeten Zwischenraum fließt. Typischer Weise weist die Viskosität einen Wert bei 25°C auf, der im Bereich von 0,1 bis 50 Pas liegt. Wenn sich der Kapillar -Underfill in dem Zwischenraum befindet kann er ausgehärtet werden. Ein No-Flow-Underfill wird üblicher Weise auf dem Sensorelement oder dem Substrat angeordnet, bevor diese beiden Komponenten miteinander verbunden werden. Insbesondere wird der No-Flow-Underfill so auf dem Sensorelement oder dem Substrat aufgebracht, dass er im fertigen Sensormodul zumindest die Trimmstruktur der Widerstandsstruktur bedeckt und insbesondere verschließt.

Das polymere Isolationsmaterial ist vorzugsweise ein duroplastisches Material. Das polymere Isolationsmaterial kann optional Füllstoff enthalten, z.B. anorganische Partikel. Diese Partikel können unter anderem dazu dienen die thermische Leitfähigkeit zu erhöhen. Das duroplastische Material umfasst oder besteht aus einem Epoxidharz, insbesondere einem Epoxidharz enthaltend Füllstoff.

Durch das polymere Isolationsmaterial wird die Trimmstruktur zumindest teilweise oder vollständig bedeckt, insbesondere verschlossen und ganz besonders bevorzugt hermetisch verschlossen. Eine optional durch einen Trimmprozess geöffnete erste anorganische Passivierungsschicht auf der Widerstandsstruktur, insbesondere auf der Trimmstruktur ist durch das polymere Isolationsmaterial verschlossen, insbesondere hermetisch verschlossen und somit vor Umwelteinflüssen geschützt. Gleichzeit kann das polymere Isolationsmaterial das Sensorelement zusätzlich mechanisch auf dem Substrat befestigen.

In einer möglichen Ausgestaltung ist das Sensormodul ein Flip Chip on Board (FCOB) oder Flip Chip-in Package. SMD-Bauteile, wie zum Beispiel die erfindungsgemäßen Sensorelemente können in face-down-Konfiguration also mit der Widerstandsstruktur hin zum Substrat verbaut werden. Wenn es sich bei dem Bauteil um eine Leiterplatte, insbesondere ein PCB handelt, spricht man auch von FCOB. Analog kann ein erfindungsgemäßes Sensorelement zusammen mit anderen Elektronikkomponenten auf einem Substrat aufgebracht werden und anschließend optional in einer Vergussmasse eingeschlossen werden. Solche Kombinationen von vergossenen Elektronik-Komponenten werden auch als *Package* bezeichnet.

In einem dritten Aspekt betrifft die Erfindung ein Verfahren zur Herstellung eines Sensormoduls, insbesondere eines Sensormoduls, wie es hierin beschrieben ist, aufweisend mindestens die folgenden Schritte:
a) Bereitstellen eines Substrats aufweisend eine erste Oberfläche, wobei auf dieser ersten Oberfläche mindestens zwei Leiterstrukturen angeordnet sind,
b) Bereitstellen eines Sensorelements aufweisend einen elektrisch isolierenden Träger aufweisend eine erste Seite und eine der ersten Seite gegenüberliegende zweite Seite, wobei eine Widerstandsstruktur auf der ersten Seite des isolierenden Trägers angeordnet ist und wobei die Widerstandsstruktur mindestens eine Sensorstruktur, mindestens eine Trimmstruktur und mindestens zwei Kontaktpads enthält,
c) Aufbringen eines Lotmaterials auf mindestens ein Kontaktpad oder auf mindestens eine Leiterstruktur,
d) Anordnen des Sensorelements auf dem Substrat, wobei die erste Seite des Trägers zur ersten Oberfläche des Substrats hin orientiert ist, unter Ausbildung eines Zwischenraums zwischen Sensorelement und Substrat,
e) Herstellen einer Lötverbindung, zwischen mindestens einem Kontaktpad und mindestens einer Leiterstruktur und
f) Einbringen eines polymeren Isolationsmaterials in den Zwischenraum zwischen Sensorelement und Substrat.

Das bereitgestellte Substrat ist vorzugsweise ein Substrat, wie es hierin beschrieben ist.

Das bereitgestellte Sensorelement ist vorzugsweise ein Sensorelement, wie es hierin beschrieben ist. In einer Ausführung enthält das Sensorelement in Schritt b) kein Lotmaterial. Die Merkmale des Sensorelements, wie sie für die ersten Aspekte beschrieben sind, gelten vorzugsweise und wo sie anwendbar sind, auch für das Sensorelement des vorliegenden Verfahrens. Das Sensorelement in Schritt b) weist einen Widerstands-Temperaturkoeffizienten von mindestens 0,003 K⁻¹ im Bereich von -50°C - 200°C, insbesondere im Bereich von 0°C - 100°C auf.

In einer besonders bevorzugten Ausführung weist das bereitgestellte Sensorelement mindestens eine offene Trimmstelle im Bereich mindestens einer Trimmstruktur auf. In einer anderen bevorzugten Ausführung enthält jedes der Kontaktpads des Sensorelements mindestens ein Kontaktpatch.

In Schritt c) wird Lotmaterial auf mindestens ein Kontaktpad oder mindestens eine Leiterstruktur aufgebracht. Das Lotmaterial ist vorzugsweise eine Lotpaste, insbesondere wie sie hierin beschrieben ist. Dem Fachmann sind geeignete Lotpasten für die Aufbau- und Verbindungstechnik bekannt und diese können vorzugsweise kommerziell erworben werden. Bevorzugt wird das Lotmaterial auf die Leiterstrukturen des Substrats aufgebracht. Das Aufbringen des mindestens einen Lotmaterials kann beispielsweise durch Dispensen oder Drucken erfolgen. Alternativ kann das Lotmaterial auf mindestens ein Kontaktpad des Sensorelements aufgebracht werden. Für den Fall, dass das Lotmaterial eine Lotpaste ist, kann das Aufbringen auf mindestens ein Kontaktpad ebenfalls mittels Dispensens oder Druckens erfolgen. Die Verwendung von Lotpaste als Lotmaterial hat den Vorteil, dass das Sensorelement auf Grund der Pastenkonsistenz am Substrat haftet und dadurch für eine Vorfixierung gesorgt werden kann.

Optional kann die Lotpaste in eine Lotkugel überführt werden. Dazu wird die Lotpaste auf dem Kontaktpad oder auf der Leiterstruktur über die Liquidustemperatur der Lotlegierung erhitzt und anschließend wieder abgekühlt. Durch die Oberflächenspannung der flüssigen Lotlegierung bildet sich ein kugelförmiges Lotmaterial - eine sogenannte Lotkugel.

In Schritt d) erfolgt ein Anordnen des Sensorelements auf dem Substrat, wobei die erste Seite des Trägers zur ersten Oberfläche des Substrats hin orientiert ist, unter Ausbildung eines Zwischenraums zwischen Sensorelement und Substrat. Nach dem Ausbilden der Lötverbindung liegt vorzugsweise zwischen Sensorelement und Substrat ein Zwischenraum vor. Anders ausgedrückt dienen die Lötverbindungen dann unter anderem als Abstandhalter. In bevorzugter Ausführung steht nach dem Anordnen des Sensorelements auf dem Substrat jedes Kontaktpad jeweils über das Lotmaterial mit mindestens einer Leiterstruktur in Kontakt. Dabei ist vorzugsweise darauf zu achten, dass das Lotmaterial nicht mehrere Kontaktpads oder Leiterstrukturen kurzschließt.

Wenn das Sensorelement auf dem Substrat angeordnet ist, erfolgt in Schritt e) die Ausbildung einer Lötverbindung zwischen mindestens einem Kontaktpad und mindestens einer Leiterstruktur, insbesondere zwischen einem oder mehreren Kontaktpads und einer oder mehreren Leiterstrukturen. Auf den Kontaktpads sind vorzugsweise Kontaktpatches angeordnet. Die Lötverbindung wird insbesondere durch Erhitzen des Lotmaterials über die Liquidustemperatur und anschließendes Abkühlen erzeugt.

Optional kann bei der Herstellung der Lötverbindung ein Flussmittel auf die Kontaktpads, auf die Leiterstrukturen und/ oder auf das Lot aufgebracht werden. Falls Flussmittel zusätzlich aufgebracht wird, kann eine Beschichtung mit Flussmittel zum Beispiel über punktuelles Dispensen, vollflächige Tauchbeschichtung, vollflächige oder maskierte Sprühbeschichtung, oder anderer gängiger Druckverfahren (Offset, Tiefdruck, etc.) erfolgen. Für den Fall, dass das Lotmaterial, insbesondere die Lotpaste, bereits Flussmittel enthält, kann auf ein separates Aufbringen von Flussmittel verzichtet werden.

In Schritt f) wird in den Zwischenraum zwischen Sensorelement und Substrat ein polymeres Isolationsmaterial eingebracht. Dazu wird vorzugsweise ein flüssiger Isolationsmaterial-Vorläufer bereitgestellt. Der Isolationsmaterial-Vorläufer ist bevorzugt ausgebildet ein polymeres Isolationsmaterial zu bilden. Der Isolationsmaterial-Vorläufer kann z.B. ein flüssiger Underfill-Vorläufer sein. Der flüssige Isolationsmaterial-Vorläufer wird in den gebildeten Zwischenraum zwischen Substrat und elektrisch isolierendem Träger eingebracht. Vorzugsweise wird der Isolationsmaterial-Vorläufer direkt an der Öffnung des Zwischenraums appliziert und fließt dann in den Zwischenraum. Üblicherweise ist die Triebkraft für das Fließen in den Zwischenraum zwischen Substrat und Sensorelement die Kapillarkraft. Daher kann der Isolationsmaterial-Vorläufer auch Kapillar-Underfill genannt werden. Besonders bevorzugt fließt der Isolationsmaterial-Vorläufer so in den Zwischenraum, dass auf dem Sensorelement vorhandene offene Trimmstellen bedeckt werden. Vorzugsweise füllt der Isolationsmaterial -Vorläufer den Zwischenraum teilweise oder vollständig aus. Kommerzielle Kapillar-Underfills sind beispielsweise von der Firma Henkel AG & Co. KGaA (Deutschland) erhältlich.

Anschließend kann der Isolationsmaterial-Vorläufer ausgehärtet werden, unter Erhalt eines polymeren Isolationsmaterials. Das Aushärten erfolgt beispielsweise durch Einwirkung von Wärme, UV-Licht, Feuchtigkeit oder reaktive Substanzen. Reaktive Substanzen können zum Beispiel Initiatoren sein.

Bei dem so hergestellten Sensormodul dient das polymere Isolationsmaterial bevorzugt gleichzeitig dazu, die Widerstandsstruktur bzw. darin enthaltenen offenen Trimmstellen zu verschließen und gleichzeitig die mechanische Anbindung des Sensorelements an das Substrat zu verbessern.

In einer bevorzugten Ausführungsform bedeckt das polymere Isolationsmaterial nicht nur offene Trimmstellen, sondern auch die Sensorstruktur und optional zugängliche Bereiche der Kontaktpads. In einer besonders bevorzugten Ausführungsform umgibt das polymere Isolationsmaterial die Lotverbindungen zumindest teilweise oder vollständig.

In einer möglichen Ausgestaltung des Verfahrens gemäß dem dritten Aspekt kann der Isolationsmaterial-Vorläufer, der in das polymere Isolationsmaterial umgewandelt wird, in den Zwischenraum zwischen Sensorelement und Substrat eingebracht werden, bevor das Lotmaterial in eine Lötverbindung umgewandelt wird. In diesem Fall wird beim Herstellen der Lötverbindung in Schritt e) gleichzeitig das polymere Isolationsmaterial erzeugt.

In einem vierten Aspekt betrifft die Erfindung ein alternatives Verfahren zur Herstellung eines Sensormoduls, insbesondere eines Sensormoduls wie es hierin beschrieben ist, aufweisend mindestens die folgenden Schritte:
a) Bereitstellen eines Substrats aufweisend eine erste Oberfläche, wobei auf dieser ersten Oberfläche mindestens zwei Leiterstrukturen angeordnet sind,
b) Bereitstellen eines Sensorelements aufweisend einen elektrisch isolierenden Träger aufweisend eine erste Seite und eine der ersten Seite gegenüberliegende zweite Seite, wobei eine Widerstandsstruktur auf der ersten Seite des isolierenden Trägers angeordnet ist und wobei die Widerstandsstruktur mindestens eine Sensorstruktur, mindestens eine Trimmstruktur und mindestens zwei Kontaktpads enthält,
c) Aufbringen eines Lotmaterials auf mindestens ein Kontaktpad oder mindestens eine Leiterstruktur,
d) Auftragen eines Isolationsmaterial-Vorläufers auf die erste Seite des elektrisch isolierenden Trägers im Bereich der Widerstandsstruktur oder auf die erste Oberfläche des Substrats zwischen die mindestens zwei Leiterstrukturen,
e) Anordnen des Sensorelements auf dem Substrat, sodass die Kontaktpads der Widerstandsstruktur mit den Leiterstrukturen über das Lotmaterial verbunden sind, und
f) Herstellen einer Lötverbindung, zwischen mindestens einem Kontaktpad und mindestens einer Leiterstruktur und Ausbildung eines polymeren Isolationsmaterials im Zwischenraum zwischen dem Sensorelement und dem Substrat.

Vorzugsweise erfolgt die Durchführung des Verfahrens in der Reihenfolge der beschriebenen Schritte. Optional können vor, zwischen oder nach einzelnen Schritten weitere Schritte erfolgen, wenn dies für die Erfindung zweckdienlich ist. Bevorzugt können die Merkmale, wie sie in den vorangegangenen Aspekten der Erfindung für die Komponenten des Sensormoduls beschrieben wurden, sofern anwendbar, auch für den vierten Aspekt der Erfindung gelten.

Die Schritte a) bis c) erfolgen analog zum dritten Aspekt der Erfindung.

Das Sensorelement in Schritt b) weist einen Widerstands-Temperaturkoeffizienten von mindestens 0,003 K⁻¹ im Bereich von -50°C - 200 °C, insbesondere im Bereich von 0°C - 100°C auf.

In Schritt d) erfolgt ein Auftragen eines Isolationsmaterial-Vorläufers auf mindestens einen Teil der ersten Seite des elektrisch isolierenden Trägers im Bereich der Widerstandsstruktur oder auf mindestens einen Teil der ersten Oberfläche des Substrats zwischen die mindestens zwei Leiterstrukturen. Der Isolationsmaterial-Vorläufer ist in diesem Aspekt der Erfindung vorzugsweise ein Underfill-Vorläufer, insbesondere ein No-Flow Underfill-Vorläufer.

Der Isolationsmaterial-Vorläufer wird vorzugsweise so angeordnet, dass er entweder auf der Widerstandsstruktur angeordnet ist oder so auf dem Substrat angeordnet ist, dass er nach dem Positionieren in Schritt e) auf der Widerstandsstruktur angeordnet ist. Insbesondere wird der Isolationsmaterialvorläufer auf die Trimmstruktur der Widerstandsstruktur aufgetragen und ganz besonders bevorzugt auf optional vorhandene Trimmstellen. Diese Trimmstellen sind insbesondere zu diesem Zeitpunkt nicht verschlossen. Unter einer nicht verschlossenen Trimmstelle kann insbesondere eine Stelle in der Trimmstruktur verstanden werden, die nach dem Materialabtrag, dem Trimmen, nicht weiterbearbeitet wurde. Beim Trimmen wird die Widerstandsstruktur auf einen Nennwiderstand eingestellt. Der Nennwiderstand auf den der Widerstand des Sensorelements bei 0 °C eingestellt wird beträgt vorzugsweise 50 Ohm, 100 Ohm, 250 Ohm, 1000 Ohm, 2500 Ohm, 5000 Ohm oder 10000 Ohm.

Das polymere Isolationsmaterial bedeckt bevorzugt die Trimmstruktur. Vorzugsweise bedeckt das polymere Isolationsmaterial auch die Sensorstruktur der Widerstandsstruktur. Zumindest die vorhandene Trimmstellen werden vorzugsweise durch das polymere Isolationsmaterial bedeckt. Vorzugsweise werden Trimmstellen verschlossen und ganz besonders bevorzugt hermetisch verschlossen. In einer besonders bevorzugten Ausführungsform füllt das polymere Isolationsmaterial den Zwischenraum zwischen Sensorelement und Substrat teilweise oder vollständig aus. Dadurch können eine oder mehrere Trimmstellen vor Umwelteinflüssen wie Sauerstoff und Luftfeuchtigkeit geschützt werden.

In Schritt e) erfolgt ein Anordnen des Sensorelements auf dem Substrat wobei die erste Seite des Trägers zur ersten Oberfläche des Substrats hin orientiert ist.

In Schritt f) erfolgt das Herstellen einer Lötverbindung, zwischen mindestens einem Kontaktpad und mindestens einer Leiterstruktur und Ausbildung eines polymeren Isolationsmaterials zwischen dem Sensorelement und dem Substrat. Das polymere Isolationsmaterial entsteht durch Umwandlung des Isolationsmaterial-Vorläufers. Die Lötverbindung entsteht insbesondere durch Aufschmelzen des Lotmaterials und anschließendes Abkühlen. Das polymere Isolationsmaterial entsteht vorzugsweise durch Polymerisation und Vernetzung des Isolationsmaterial-Vorläufers.

### Kurzbeschreibung der Abbildungen

Abbildung 1 zeigt ein Sensormodul gemäß dem Stand der Technik
Abbildung 2 zeigt ein bevorzugtes Verfahren zur Herstellung eines Sensormoduls gemäß der Erfindung
Abbildung 3 zeigt ein alternatives Verfahren zur Herstellung eines Sensormoduls gemäß der Erfindung.
Abbildung 4 zeigt ein vereinfachtes Flussdiagramm eines möglichen Verfahrens zur Herstellung eines erfindungsgemäßen Sensormoduls.
Abbildung 5 zeigt ein vereinfachtes Flussdiagramm eines alternativen Verfahrens zur Herstellung eines erfindungsgemäßen Sensormoduls.

### Beschreibung der Abbildungen

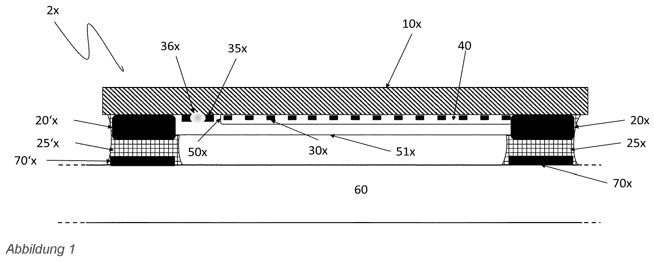

Abbildung 1 zeigt ein Sensormodul (2x) gemäß dem Stand der Technik. Auf einem isolierenden Träger 10x) ist eine Widerstandsstruktur mit einer Sensorstruktur (30x) und einer Trimmstruktur (35x) und Kontaktpads (20x, 20'x) angeordnet. Die Widerstandsstruktur ist mit einer Isolierschicht (50x) abgedeckt, die insbesondere die Sensorstruktur vor weiterer Manipulation schützen kann. Die Trimmstruktur (35x) weist eine Trimmstelle (36x) auf, wobei die Trimmstruktur und die Isolierschicht (50x) mit der darunter liegenden (Sensorstruktur 30x) von einer Abdeckschicht (51x) bedeckt ist, die die Trimmstruktur (35x) mit der Trimmstelle (36x) verschließt. Die Widerstandsstruktur enthält weiterhin Kontaktpads (20x, 20'x) die über eine Lötverbindung (25x, 25'x) mit Leiterstrukturen (70x, 70'x) auf dem Substrat (60x) angeordnet sind. Zwischen dem Sensorelement und dem Substrat (60) und insbesondere zwischen der Abdeckschicht (51x) und der Oberfläche des Substrats kann ein Zwischenraum vorliegen. Da die Abdeckschicht (51x) die Trimmstelle (36x) verschließt kann auf eine Füllung des Zwischenraums verzichtet werden. Nachteilig ist, dass vor der Herstellung der Lötverbindungen (25x, 25'x) zwei Schichten zum Schutz der Widerstandsstruktur aufgetragen werden müssen (50x, 51x).

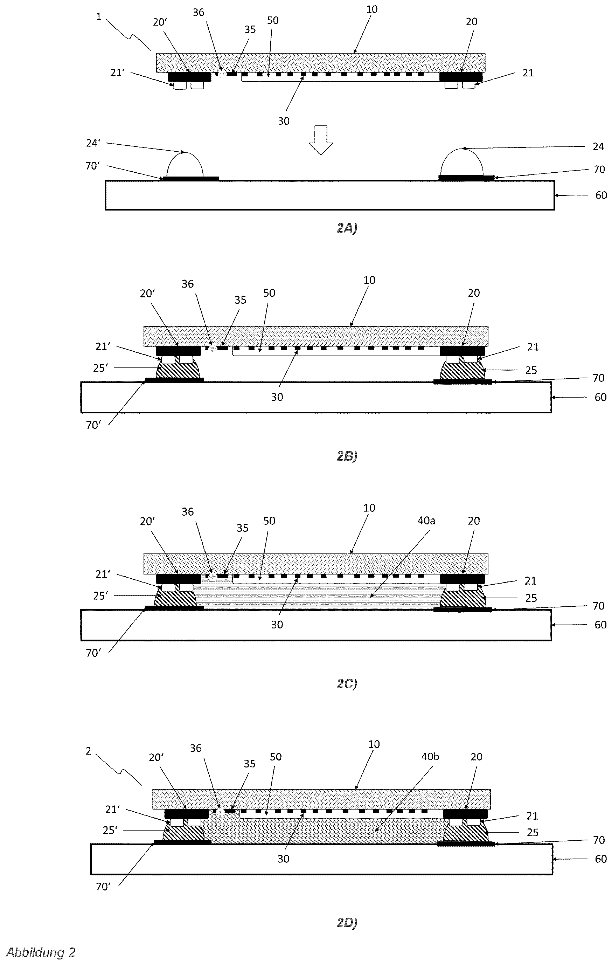

Abbildung 2 zeigt ein mögliches Verfahren zur Herstellung eines erfindungsgemäßen Sensormodules 2. Zuerst wird ein in Abbildung 2A) Sensorelement (1) bereitgestellt. Das Sensorelement umfasst einen elektrisch isolierenden Träger (10) auf dessen erster Seite eine Widerstandsstruktur aufgebracht ist. Die Widerstandsstruktur umfasst eine Sensorstruktur (30), eine Trimmstruktur (35) und Kontaktpads (20, 20'). Wie hier dargestellt, können optional auf den Kontaktpads (20, 20') jeweils ein oder mehrere Kontaktpatches (21, 21') angeordnet sein. Die Kontaktpatches (21,21') können dazu dienen die Lötbarkeit der Kontaktpads (20, 20') zu verbessern. Die Sensorstruktur (30) ist vorzugsweise mit einer Isolierschicht (50) bedeckt. Optional kann die Sensorstruktur (30) nicht von einer Isolierschicht (50) bedeckt sein. Die Trimmstruktur (35) weist vorzugsweise eine Trimmstelle (36) auf. Das Substrat (60) weist auf einer ersten Oberfläche mindestens zwei Leiterstrukturen (70, 70') auf. Der elektrisch isolierende Träger (10) ist mit seiner ersten Seite zur ersten Oberfläche des Substrats (60) hin orientiert. Auf den Leiterstrukturen (70, 70') ist ein Lotmaterial (24, 24') angeordnet, das optional eine Lotpaste sein kann.

In Abbildung 2B) wird das Sensorelement (1) so auf dem Substrat (60) positioniert, dass die erste Seite des Sensorelements zur ersten Oberfläche des Substrats (60) hin orientiert ist. Die Kontaktpads (20, 20') der Widerstandsstruktur werden hierbei mit den Leiterstrukturen (70, 70') über das Lotmaterial (24, 24') verbunden. Das Lotmaterial (24, 24') wird anschließend in eine Lotverbindung (25, 25') überführt. Dies erfolgt vorzugsweise durch Erhitzen. Durch das Anordnen mit dem anschließenden Ausbilden der Lötverbindung (25, 25') wird ein Zwischenraum, auch Spalt genannt, zwischen der ersten Seite des Sensorelements und der ersten Oberfläche des Substrats (60) erzeugt. Die optional vorliegende Trimmstelle (36) innerhalb des Zwischenraums ist zu diesem Zeitpunkt vorzugsweise nicht bedeckt.

Im nächsten Schritt wird in Abbildung 2C) ein Isolationsmaterial-Vorläufer (40a), vorzugsweise in bei Raumtemperatur flüssiger Form, in den Zwischenraum zwischen Sensorelement (1) und Substrat (60) eingebracht.

Im Schritt in Abbildung 2D) wird im Zwischenraum zwischen der ersten Seite des Sensorelements und der ersten Oberfläche des Substrats ein polymeres Isolationsmaterial (40b) ausgebildet. Dazu wird der flüssige Isolationsmaterial-Vorläufer (40a) in ein polymeres Isolationsmaterial (40b) umgewandelt, z.B. durch Erhitzen. Das polymere Isolationsmaterial (40b) wird vorzugsweise auch als Underfill-Material bezeichnet. Das polymere Isolationsmaterial bedeckt die Trimmstruktur (35) mit der optional vorhandenen Trimmstelle (36). Bevorzugt kann das polymere Isolationsmaterial (40b) für eine Passivierung der zugänglichen Bereiche der Widerstandsstruktur sorgen.

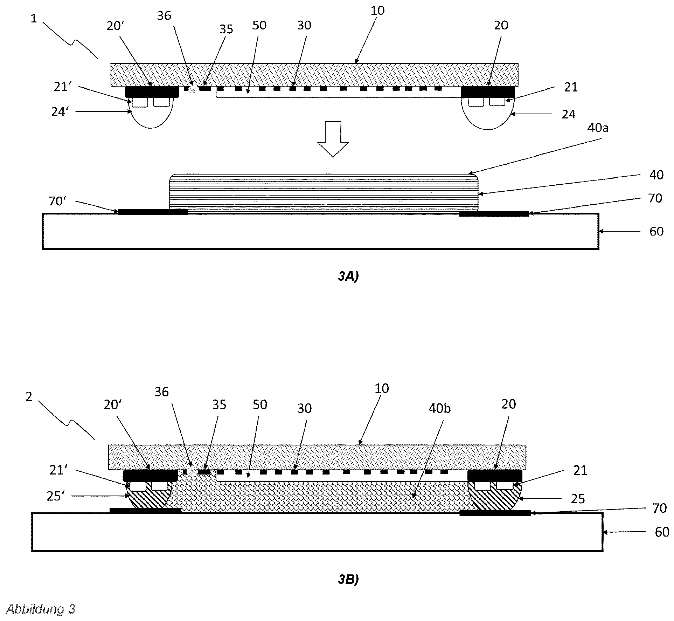

Abbildung 3 zeigt weiteren möglichen Prozess zur Herstellung eines erfindungsgemäßen Sensormoduls (2). Zuerst wird wie in Abbildung 3A) dargestellt ein Sensorelement (1) bereitgestellt. Das Sensorelement enthält einen elektrisch isolierenden Träger (10) aufweisend eine Widerstandsstruktur auf einer ersten Seite des isolierenden Trägers, wobei die Widerstandsstruktur mindestens eine Sensorstruktur (30), mindestens eine Trimmstruktur (35) und mindestens zwei Kontaktpads (20) enthält. Auf der Sensorstruktur (30) ist eine Isolierschicht (50) angeordnet. Die Trimmstruktur (35) ist nicht von der optionalen Isolierschicht (50) bedeckt und weist optional eine Trimmstelle (36) auf. Auf den Kontaktpads (20, 20') sind optional Kontaktpatches (21, 21') vorgesehen und auf den Kontaktpads ist ein Lotmaterial (24, 24') angeordnet. In einer alternativen Ausführung kann das Lotmaterial (24, 24') auch auf den Leiterstrukturen (70, 70') angeordnet sein. Die erste Seite des elektrisch Isolierenden Trägers (10), auf der die Widerstandsstruktur aufgebracht ist, ist zur ersten Oberfläche des Substrats (60) hin orient. Auf dem Substrat ist ein Isolationsmaterial-Vorläufer (40a) angeordnet. Dies Isolationsmaterial-Vorläufer (40a) bedeckt die Leiterstrukturen (70, 70') zumindest teilweise nicht.

Im nächsten Schritt wird in Abbildung 3B) das Sensorelement (1) so auf dem Substrat (60) angeordnet, dass das Lotmaterial (24, 24') die Leiterstrukturen (70, 70') kontaktiert. Der Isolationsmaterial-Vorläufer (40a) liegt zwischen dem Sensorelement (1) und dem Substrat (60) und bedeckt die Trimmstruktur (35) mit der optionalen Trimmstelle (36). Vorzugsweise füllt der Isolationsmaterial-Vorläufer (40a) den Zwischenraum zwischen Sensorelement und Substrat vollständig aus. Anschließend wird die Anordnung aus Sensorelement (1) und Substrat (60) erhitzt, sodass eine Lotverbindung (25, 25') zwischen den Kontaktpads (20, 20') und den Leiterstrukturen (70, 70') ausgebildet wird. Dabei wird vorzugsweise der Isolationsmaterial-Vorläufer (40a) in ein polymeres Isolationsmaterial (40b) umgewandelt.

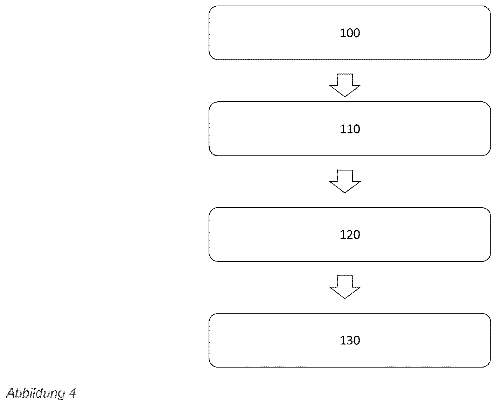

Abbildung 4 zeigt ein vereinfachtes Flussdiagramm zum einem möglichen Herstellungsverfahren gemäß der Erfindung. In Schritt (100) wird ein Sensorelement (1) und ein Substrat (60) bereitgestellt und das Sensorelement auf dem Substrat positioniert. Dies entspricht den Schritten a) bis d) im Verfahren gemäß dem dritten Aspekt der Erfindung allgemeinen Teil der Beschreibung. In Schritt (110) wird die Lötverbindung zwischen den Kontaktpads des Sensorelements und den Leiterstrukturen auf dem Substrat hergestellt. In Schritt (120) wird ein Isolationsmaterial-Vorläufer in den Zwischenraum zwischen Sensorelement und Substrat eingebracht. Der Isolationsmaterial-Vorläufer ist vorzugsweise ein Kapillar-Underfill. Der Kapillar-Underfill wird in flüssiger Form in den Zwischenraum eingebracht. In Schritt (130) wird der Isolationsmaterial-Vorläufer in ein polymeres Isolationsmaterial umgewandelt. Dieser Vorgang wird auch Aushärten oder *Curing* genannt. Vorzugsweise erfolgt die Umwandlung durch Erhitzen.

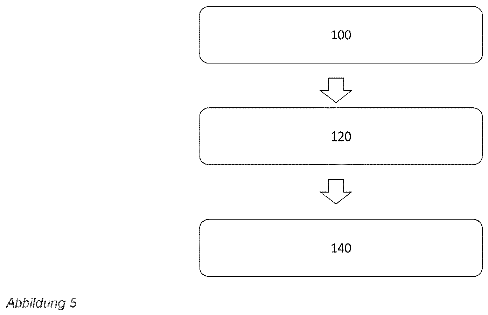

Abbildung 5 zeigt ein vereinfachtes Flussdiagramm zu einem möglichen Verfahren zur Herstellung des erfindungsgemäßen Sensormoduls. Schritt (100) erfolgt analog zur Abbildung 4. Optional kann in Schritt (100) nach dem Positionieren ein Trocknungsschritt enthalten sein, mit dem das Lotmaterial, insbesondere eine Lotpaste, getrocknet wird. In dieser Ausführungsform umfasst Schritt (100) In Schritt (120) wird ein Isolationsmaterial-Vorläufer in den Zwischenraum zwischen Sensorelement und Substrat eingebracht. In Schritt (140) wird gleichzeitig das Lotmaterial (24,24') in eine Lötverbindung (25, 25') umgewandelt und der Isolationsmaterial-Vorläufer in ein polymeres Isolationsmaterial. Die Umwandlung erfolgt vorzugsweise durch Erhitzen.

### Verzeichnis der Bezugsziffern

1 Sensorelement
2 Sensormodul
10 elektrisch isolierender Träger
20, 20' Kontaktpads
21, 21' Kontaktpatches
24, 24' Lotmaterial
25, 25' Lotverbindungen
30 Sensorstruktur
35 Trimmstruktur
36 Trimmstelle
40a Isolationsmaterial-Vorläufer
40b polymeres Isolationsmaterial
50 Isolierschicht
51x Abdeckschicht
60 Substrat
70, 70' Leiterstrukturen
100, 110, 120, 130, 140 Verfahrensschritte zu möglichen Herstellungsverfahren des erfindungsgemäßen Sensormoduls

## Patentansprüche

1. Sensorelement (1), aufweisend
- einen elektrisch isolierenden Träger (10) aufweisend eine erste Seite und eine der ersten Seite gegenüberliegende zweite Seite und
- eine Widerstandsstruktur angeordnet auf der ersten Seite des elektrisch isolierenden Trägers (10), wobei die Widerstandsstruktur mindestens eine Sensorstruktur (30), mindestens eine Trimmstruktur (35) und mindestens zwei Kontaktpads (20, 20') enthält,
**dadurch gekennzeichnet, dass** auf mindestens einem Kontaktpad (20, 20') ein Lotmaterial, angeordnet ist.

2. Sensorelement (1) gemäß Anspruch 1, wobei die Widerstandsstruktur (30) zumindest im Bereich außerhalb der mindestens einen Trimmstruktur (35) zumindest teilweise mit einer Isolierschicht (50) bedeckt ist.

3. Sensorelement (1) gemäß einem der Ansprüche 1 oder 2, wobei die Isolierschicht (50) die Trimmstruktur zumindest teilweise nicht bedeckt und die Isolierschicht (50) ein dielektrisches Material umfasst, das ausgewählt ist aus der Gruppe enthaltend Polymere, Gläser, Keramiken und Glaskeramiken.

4. Sensorelement (1) gemäß einem der Ansprüche 1 - 3, wobei die mindestens eine Trimmstruktur (35) mindestens eine Trimmstelle (36) aufweist.

5. Sensorelement (1) gemäß einem der Ansprüche 1 - 4, wobei die Trimmstruktur (35) nicht von mindestens einer weiteren Passivierungsschicht oder einer Abdeckschicht zumindest teilweise bedeckt ist.

6. Sensorelement (1) gemäß einem der Ansprüche 1 - 5, wobei mindestens ein Kontaktpad (20, 20') der Widerstandsstruktur mindestens ein Kontaktpatch (21, 21') aufweist,

7. Sensorelement gemäß einem der Ansprüche 1 - 6, wobei der isolierende Träger (10) flexibel ist.

8. Sensorelement (1) gemäß einem der Ansprüche 1 - 7, wobei die erste Seite des Sensorelements (1) eine Fläche aufweist, die höchstens 1 mm² beträgt

9. Sensorelement (1) gemäß einem der Ansprüche 1 - 8, wobei das Sensorelement (1) eine Dicke von höchstens 200 µm aufweist.

10. Sensorelement (1) gemäß einem der Ansprüche 1 - 9, wobei die Widerstandsstruktur im Bereich der Trimmstruktur (35) eine Trimmstelle aufweist und auf einen Nennwiderstand eingestellt ist und wobei der Nennwiderstand bei 0°C 50 Ohm, 100 Ohm, 250 Ohm, 1000 Ohm, 2500 Ohm, 5000 Ohm oder 10000 Ohm beträgt.

11. Sensormodul (2) aufweisend
• ein Sensorelement (1), insbesondere gemäß einem der Ansprüche 1 - 10, umfassend einen elektrisch isolierenden Träger (10) aufweisend eine erste Seite und eine der ersten Seite gegenüberliegende zweite Seite, wobei eine Widerstandsstruktur auf der ersten Seite des isolierenden Trägers (10) angeordnet ist und wobei die Widerstandsstruktur mindestens eine Sensorstruktur (30), mindestens eine Trimmstruktur (35) und mindestens zwei Kontaktpads (20, 20') enthält, und
• ein Substrat (60) aufweisend eine erste Oberfläche mit mindestens zwei darauf angeordneten Leiterstrukturen (70, 70'),
wobei das Sensorelement (1) mit der ersten Seite des isolierenden Trägers (10) hin zur ersten Oberfläche des Substrats (60) angeordnet ist, **dadurch gekennzeichnet, dass** zwischen mindestens einem Kontaktpad (20, 20') des Sensorelements (1) und mindestens einer Leiterstruktur (70, 70') des Substrats (60) eine Lotverbindung (25, 25') ausgebildet ist und dass zwischen dem Sensorelement (1) und dem Substrat (60) zumindest ein polymeres Isolationsmaterial (40b) vorliegt und bevorzugt mindestens die Trimmstruktur (35) bedeckt.

12. Sensormodul (2) gemäß Anspruch 11, wobei das polymere Isolationsmaterial (40b) die mindestens eine Trimmstruktur (35) zumindest teilweise oder vollständig bedeckt, insbesondere verschließt und ganz besonders bevorzugt hermetisch verschließt.

13. Sensormodul (2) gemäß Anspruch 11 oder 12, wobei die mindestens eine Trimmstruktur (35) mindestens eine Trimmstelle (36) aufweist.

14. Sensormodul (2) gemäß einem der Ansprüche 11 - 13, wobei das polymeres Isolationsmaterial (40b) ein duroplastisches Material aufweist, insbesondere ein duroplastisches Material enthaltend einen Füllstoff.

15. Verfahren zur Herstellung eines Sensormoduls (2), insbesondere eines Sensormoduls (2), gemäß einem der Ansprüche 11 - 14, aufweisend mindestens die folgenden Schritte:
a) Bereitstellen eines Substrats (60) aufweisend eine erste Oberfläche, wobei auf dieser ersten Oberfläche mindestens zwei Leiterstrukturen (70, 70') angeordnet sind,
b) Bereitstellen eines Sensorelements (1) aufweisend einen elektrisch isolierenden Träger (10) aufweisend eine erste Seite und eine der ersten Seite gegenüberliegende zweite Seite, wobei eine Widerstandsstruktur auf der ersten Seite des isolierenden Trägers angeordnet ist und wobei die Widerstandsstruktur mindestens eine Sensorstruktur (30), mindestens eine Trimmstruktur (35) und mindestens zwei Kontaktpads (20, 20') enthält,
c) Aufbringen eines Lotmaterials (24, 24') auf mindestens ein Kontaktpad (20, 20') oder auf mindestens eine Leiterstruktur (70, 70')
d) Anordnen des Sensorelements (1) auf dem Substrat (60), wobei die erste Seite des Trägers (10) zur ersten Oberfläche des Substrats (60) hin orientiert ist unter Ausbildung eines Zwischenraums zwischen Sensorelement (1) und Substrat (60),
e) Herstellen einer Lötverbindung (25, 25'), zwischen mindestens einem Kontaktpad (20, 20') und mindestens einer Leiterstruktur (70, 70') und
f) Einbringen eines, polymeren Isolationsmaterial (40b) in den Zwischenraum zwischen Sensorelement (1) und Substrat (60).

16. Verfahren gemäß Anspruch 15, wobei das Herstellen der Lötverbindung (25, 25') umfasst:
• Optional aufbringen eines Flussmittels auf eine der Komponenten ausgewählt aus Kontaktpads (20, 20'), Leiterstrukturen (70, 70') und Lotmaterial (24, 24'),
• Erhitzen des Lotmaterials über die Liquidustemperatur der enthaltenen Lotlegierung und anschließendes Abkühlen unter Ausbildung einer Lötverbindung (25, 25').

17. Verfahren gemäß einem der Ansprüche 15 oder 16, wobei in Schritt f) ein flüssiger Isolationsmaterial-Vorläufer (40a) bereitgestellt wird, der in den Zwischenraum zwischen Substrat (60) und elektrisch isolierendem Träger fließt und anschließend ausgehärtet wird unter Erhalt eines polymeren Isolationsmaterials (40b).

18. Verfahren zur Herstellung eines Sensormoduls, insbesondere gemäß einem der Ansprüche 11 - 14, aufweisend mindestens die folgenden Schritte:
a) Bereitstellen eines Substrats (60) aufweisend eine erste Oberfläche, wobei auf dieser ersten Oberfläche mindestens zwei Leiterstrukturen (70, 70') angeordnet sind,
b) Bereitstellen eines Sensorelements (1) aufweisend einen elektrisch isolierenden Träger (10) aufweisend eine erste Seite und eine der ersten Seite gegenüberliegende zweite Seite, wobei eine Widerstandsstruktur auf der ersten Seite des isolierenden Trägers (10) angeordnet ist und wobei die Widerstandsstruktur mindestens eine Sensorstruktur (30), mindestens eine Trimmstruktur (35) und mindestens zwei Kontaktpads (20, 20') enthält,
c) Aufbringen eines Lotmaterials (24, 24') auf mindestens ein Kontaktpad (20, 20') oder mindestens eine Leiterstruktur (70, 70'),
d) Auftragen eines Isolationsmaterial-Vorläufers (40a) auf die erste Seite des elektrisch isolierenden Trägers (10) im Bereich der Widerstandsstruktur oder auf die erste Oberfläche des Substrats (60) zwischen die mindestens zwei Leiterstrukturen (70, 70'),
e) Anordnen des Sensorelements (1) auf dem Substrat (60), sodass die Kontaktpads (20, 20') der Widerstandsstruktur mit den Leiterstrukturen (70, 70') über das Lotmaterial (24, 24') verbunden sind, und
f) Herstellen einer Lötverbindung (25, 25'), zwischen mindestens einem Kontaktpad (20, 20') und mindestens einer Leiterstruktur (70, 70') und Erzeugen eines polymeren Isolationsmaterials (40b) zwischen dem Sensorelement (1) und dem Substrat (60).
